# DEMANDE DE BREVET EUROPEEN

(11) **EP 0 670 634 A1**
(43) Date de publication de la demande: **06.09.1995**
(21) Numéro de dépôt: 95400337.2
(22) Date de dépôt: 16.02.1995
(51) Int. Cl.: H03K 19/21

(54) **Porte OU-Exclusif intégrée dans un semi-conducteur III-V**

(30) Priorité: 23.02.1994 FR 9402061
(71) Demandeur: BULL S.A., F-78430 Louveciennes (FR)
(72) Inventeur: Bedouani, Mohamed, F-78220 Viroflay (FR)
(74) Mandataire: Denis, Hervé

(57) **Abrégé**

La porte logique XOR (10) à deux entrées binaires a, b comprend une porte d'entrée NOR (11) recevant les entrées a, b, deux circuits de retard (13a, 13b) pour retarder les entrées respectives a et b de façon à compenser sensiblement le retard fourni par la porte d'entrée, et une paire de portes NOR (12a, 12b) recevant en commun le signal de sortie (A1) de la porte d'entrée NOR et les entrées respectives a et b retardés et ayant une sortie commune (A) pour former une fonction OR des signaux de sortie (A1, A2) de la paire de portes. L'invention s'applique notamment aux circuits intégrés dans un semi-conducteur III-V (GaAs, AlGaAs / GaAs, ...) en logique BDCFL avec des transistors MESFET ou HEMT.

## Description

### Domaine technique.

L'invention se rapporte aux portes logiques de type OU-Exclusif, effectuant la fonction logique OU-Exclusif ou la fonction inverse NON-OU-Exclusif et appelées couramment portes de type XOR (XOR ou NXOR), intégrées dans un semi-conducteur. Elle s'applique plus particulièrement aux portes XOR à vitesse de commutation rapide, par exemple supérieure à 1 gigabit par seconde, telles que celles intégrées dans un semi-conducteur III-V tel que l'arséniure de gallium (GaAs). Dans cette application, la porte de type XOR conforme à l'invention peut être faite de transistors à effet de champ, surtout ceux de type MESFET (Metal-Semiconductor Field-Effect Transistor) et convient alors plus particulièrement à la logique BDCFL (Buffered Direct-Coupled FET Logic). Elle peut aussi être faite de transistors à effet de champ du type HEMT (High-Electron-Mobility Transistor) intégrés dans un matériau semi-conducteur ternaire tel que l'arséniure de gallium et d'aluminium du type AlGaAs / GaAs par exemple.

### L'art antérieur.

On sait que la fonction XOR de deux entrées logiques a et b est la somme des deux impliquants premiers ab* et a*.b, où a* et b* sont les compléments de a et b (a ⊕ b = a*b v ab*). En logique SCFL (Source-Coupled FET Logic) faite de transistors à effet de champ dans l'arséniure de gallium comme en logique ECL (Emitter-Coupled Logic) faite de transistors bipolaires, la porte XOR à deux entrées couramment utilisée forme un circuit à deux étages d'amplificateurs différentiels superposés entre deux potentiels d'alimentation, ordinairement désignés par exemple par Vdd et Vss en technologie à transistors à effet de champ. Dans chaque amplificateur différentiel, les transistors sont du même type (à déplétion ou à enrichissement) et forment une paire différentielle et symétrique pour fonctionner alternativement. Dans la porte XOR à deux étages, les transistors de l'amplificateur différentiel inférieur ont leurs sources alimentées par une source de courant constant connectée à un premier potentiel d'alimentation (Vss). Leurs grilles reçoivent les deux signaux complémentaires de l'entrée a et leurs drains ont chacun pour charge l'étage supérieur. L'étage supérieur comprend deux amplificateurs différentiels recevant chacun les signaux complémentaires de l'autre entrée b, et deux résistances de charge. Les paires de transistors symétriques constituant les deux amplificateurs différentiels ont leurs sources connectées aux drains respectifs des deux transistors de l'étage inférieur et leurs grilles reçoivent les signaux respectifs complémentaires b, b*. L'un des transistors de l'un des deux amplificateurs différentiels et le transistor symétrique de l'autre amplificateur différentiel ont leurs drains réunis et reliés au second potentiel d'alimentation (Vdd) par l'intermédiaire de l'une des résistances de charge. Les deux résistances de charge fournissent ainsi les deux tensions complémentaires représentatives de la fonction de type XOR (XOR et NXOR) des deux entrées a et b. Ces deux tensions sont appliquées à deux étages suiveurs pour délivrer les signaux de sortie.

Cette porte XOR offre l'avantage d'être très compacte. Cependant, les temps de propagation des signaux entre les bornes d'entrée et les bornes de sortie sont très différents selon que les signaux d'entrée sont a, a* ou b, b*. Les signaux a, a* traversent les transistors respectifs de l'étage inférieur et ceux de l'étage supérieur, tandis que les signaux b, b* ne traversent que les transistors respectifs de l'étage supérieur. Si cette porte est appliquée dans un système à logique asynchrone, elle convient bien aux circuits les plus lents, par exemple dans une horloge connectée à la sortie la plus lente du système. Mais en logique asynchrone la différence entre les temps de propagation se répercute sur les circuits qui suivent et altère le fonctionnement du système.

D'autre part, les logiques DCFL et BDCFL destinées aux circuits intégrés de haute densité dans l'arséniure de gallium offrent le double avantage d'avoir des portes ayant une structure simple et de nécessiter une faible consommation énergétique sous une basse tension d'alimentation, ordinairement de deux volts. En logique DCFL, une porte XOR est ordinairement faite de quatre portes NOR à deux entrées, et d'un inverseur. Les deux entrées a et b sont appliquées aux deux bornes d'entrée d'une porte NOR d'entrée et aux premières bornes d'entrée respectives de deux portes NOR intermédiaires, dont les deux secondes bornes d'entrée reçoivent le signal de sortie de la porte NOR d'entrée et dont les sorties sont appliquées aux deux bornes d'entrée d'une porte NOR de sortie suivie de l'inverseur. Les deux entrées a et b traversent donc successivement quatre couches, à savoir la porte d'entrée, l'une des deux portes intermédiaires, la porte de sortie et l'inverseur. Le temps de propagation dans cette porte XOR correspond donc à environ quatre fois le temps de propagation dans l'une des couches. D'autre part, on sait qu'en logique DCFL le temps de commutation à la montée du signal de sortie d'une porte diffère notablement du temps de commutation à la descente. Cette dissymétrie dans les temps de commutation est de l'ordre de 15% à 30% et se conserve en traversant les quatre couches de la porte XOR lorsqu'elles sont correctement dimensionnées. En outre, chacune des deux portes intermédiaires reçoit une entrée a ou b directe et la sortie commune de la porte d'entrée. En d'autres termes, leurs deux entrées reçoivent respectivement des signaux décalés dans le temps. Il en résulte des temps de commutation plus longs et un déséquilibre important entre les temps de commutation de montée et de descente. Il s'avère donc souvent nécessaire ou avantageux de mettre en forme le signal de sortie XOR, en ajoutant un tampon de sortie compatible, fait par exemple en logique BDCFL. En effet, celle logique offre l'avantage d'atténuer la dissymétrie des temps de commutation de montée et de descente. Ainsi, une porte XOR en logique BDCFL offre des temps de commutation équilibrés, mais elle nécessite toujours la traversée de quatre couches de portes. On obtient une porte NXOR en logique DCFL ou BDCFL en enlevant l'inverseur. Cette porte offre un temps de propagation plus court.

### L'invention.

L'invention remédie à ces inconvénients, en assurant un temps de propagation réduit et permettant d'équilibrer des temps de commutation de montée et de descente.

L'invention a pour objet une porte logique de type OU-Exclusif 10 à deux entrées binaires a, b, comprenant une porte d'entrée NOR recevant les entrées a, b et fournissant un signal de sortie A1, une paire de portes NOR recevant en commun le signal de sortie A1 de la porte d'entrée NOR et les entrées respectives a et b, et des moyens formant une fonction OR des signaux de sortie de la paire de portes, caractérisée en ce que la paire de portes est faite de deux amplificateurs réalisés en logique BDCFL et les moyens formant une fonction OR sont constitués par la sortie commune A de la paire de portes.

L'invention a aussi pour objet corollaire un circuit intégré incluant la porte définie précédemment.

L'invention ressort de la description qui suit, donnée à titre d'exemple et faite en référence aux dessins annexés.

Dans les dessins :
- la figure 1 illustre schématiquement la structure d'une porte XOR conforme à l'invention, faites de transistors à effet de champ de type MESFET et en logique BDCFL; et
- la figure 2 est une table de vérité de la porte XOR représentée sur la figure 1 pour en illustrer le fonctionnement.

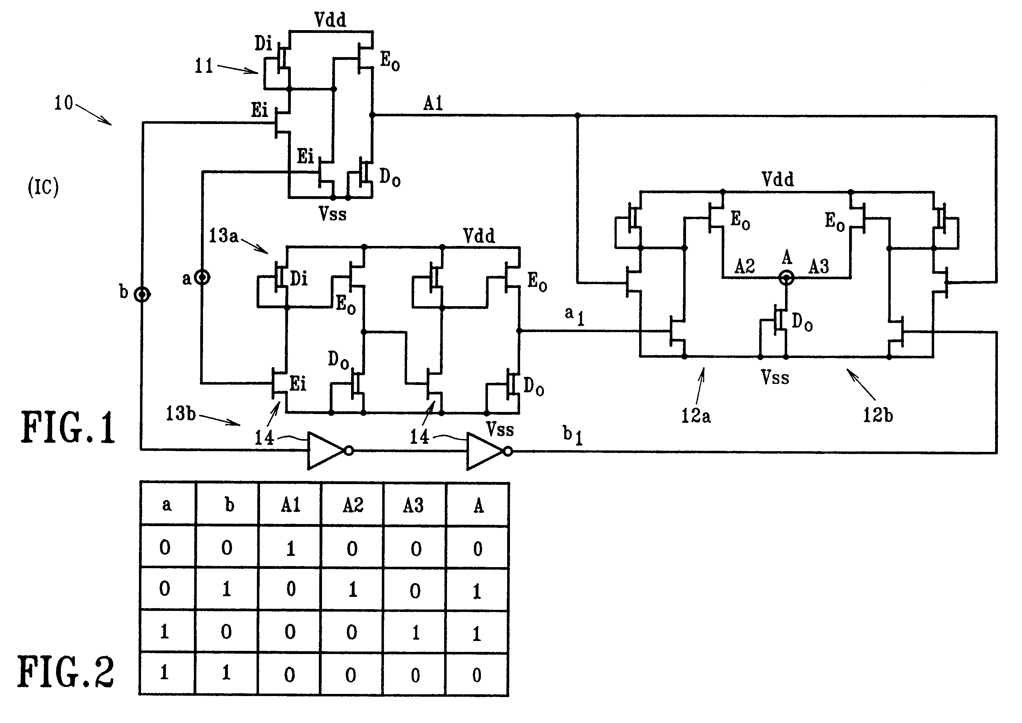

La figure 1 illustre un exemple de réalisation d'une porte logique XOR 10 conforme à l'invention, intégrée dans l'arséniure de gallium d'un circuit intégré IC et faite en logique BDCFL utilisant des transistors à effet de champ de type MESFET. La porte 10 reçoit deux entrées binaires a et b. La porte illustrée 10 comprend trois portes NOR à deux entrées, à savoir une porte d'entrée NOR 11 et une paire de portes NOR 12a, 12b, et deux circuits à retard 13a et 13b formés chacun dans l'exemple illustré de deux inverseurs en série. Les entrées a et b sont appliquées sur les deux entrées de la porte NOR 11 et sur les entrées respectives des deux circuits à retard 13a et 13b. La sortie de la porte d'entrée 11 délivre un signal d'addition binaire A1 = (a + b)*, tandis que les circuits à retard 13a et 13b délivrent respectivement les signaux retardés a₁ et b₁. Les retards respectifs des circuits à retard 13a et 13b compensent sensiblement le retard dû à la traversée de la porte d'entrée 11 et existant entre le signal A1 et les signaux a et b. Les signaux a₁, b₁ et A1 ont donc la même forme d'onde, en ce sens qu'elles ont la même phase et possèdent des temps de commutation identiques.

Les deux portes NOR 12a et 12b reçoivent sur leurs premières entrées le signal A1 et sur leurs secondes entrées les signaux respectifs a₁ et b₁. Les deux portes NOR 12a et 12b délivrent deux signaux d'addition respectifs A2 = ((a + b)* + a)* et A3 = ((a + b)* + b)*. L'addition de ces deux signaux produit le signal de sortie A = a ⊕ b.

Dans l'exemple de la figure 1, les portes 11, 12a, 12b et les inverseurs 14 sont faits en logique BDCFL de manière classique à partir d'un même circuit de base correspondant à un inverseur. Ce circuit de base comprend un transistor d'entrée à enrichissement Ei, un transistor de sortie à enrichissement Eo et de deux transistors à déplétion Di, Do ayant chacun leur grille connectée à leur source pour constituer une charge résistive. Chaque circuit de base reçoit deux potentiels d'alimentation Vdd et Vss. Chaque transistor d'entrée Ei a une source connectée au potentiel bas Vss et un drain connecté au potentiel haut Vdd par l'intermédiaire de l'un des transistors Di monté en charge active. Le transistor de sortie Eo a une grille connectée à la source du transistor Di, un drain connecté au potentiel Vdd et une source fournissant le signal de sortie et connectée au potentiel Vss par l'intermédiaire du transistor Do monté en charge active. Ce circuit de base BDCFL est ainsi fait du circuit de base DCFL que forme le transistor Ei et le transistor Di monté en charge active, auquel s'ajoute un tampon formé par le transistor Eo et le transistor Do monté en charge active. La logique BDCFL est donc compatible avec la logique DCFL. Le circuit de base BDCFL constitue aussi les inverseurs 14 formant les circuits à retard 13a et 13b. Dans les portes 11, 12a et 12b, le transistor Di est commun à deux transistors d'entrée Ei montés en parallèle. La paire de portes 12a et 12b se caractérise donc par une sortie commune. Ainsi, la sortie commune des deux portes effectue, en plus des fonctions NOR de ces portes, la fonction OR de leurs signaux de sortie. La sortie commune de la paire de portes 12a et 12b équivaut à mettre en commun le même transistor de charge Do dans les deux tampons des deux portes et évite l'adjonction d'une porte OR.

La figure 2 est une table de vérité relative à l'ensemble des portes 11, 12a et 12b et illustrant ainsi le fonctionnement de la porte XOR 10 conforme à l'invention.

Il est clair que la porte XOR 10 offre l'avantage de n'incorporer que deux couches de portes, à savoir la porte d'entrée 11 et la paire de portes 12a et 12b. La logique BDCFL des portes 12a et 12b offre aussi l'avantage d'avoir des temps de commutation plus équilibrés. L'équilibre entre les temps de montée et les temps de descente peut même être ajusté si au moins la porte d'entrée 11 et les seconds inverseurs 14 sont aussi faits en logique BDCFL comme dans l'exemple illustré. Par exemple, il est possible dans ce cas d'ajuster les largeurs de grille des transistors Eo et Do des tampons de la porte d'entrée 11 et des inverseurs 14 de façon que la charge et la décharge des capacités correspondant aux transistors d'entrée Ei respectifs se fassent dans des temps sensiblement égaux et assurent ainsi des temps de commutation équilibrés. Un rapport des largeurs de grille de l'ordre de 1 des transistors Do et Eo d'un tampon permet cet équilibrage. De plus, puisque l'avantage de la BDCFL réside essentiellement dans le montage des portes 12a et 12b, on comprend que les portes 11 et les inverseurs 14 peuvent être faits en une autre logique compatible avec la logique BDCFL, notamment la logique DCFL. Enfin, le retard entre les signaux a, b et A1, surtout si la porte 11 est faite en logique DCFL, peut ne pas déséquilibrer sensiblement les temps de commutation et peut ne pas être compensé par les inverseurs 14. En outre, cette mise en oeuvre a l'avantage d'être simple dans l'exemple illustré. En effet, la fonction OR des signaux A2 et A3 est simplement réalisée par la sortie commune de la paire de portes 12a et 12b. Cependant, la sortie A de la porte 10 illustrée pourrait être appliquée à un inverseur de sortie, par exemple identique aux inverseurs 14, de façon à obtenir une porte NXOR. Cette porte NXOR aurait des temps de commutation courts et équilibrés, mais l'addition de l'inverseur de sortie augmenterait le temps de propagation et serait comparable à la porte NXOR classique. Cependant, la porte NXOR conforme à l'invention garderait l'avantage d'offrir des temps de commutation courts et équilibrés.

On peut donc en déduire que, d'une manière générale, l'invention a pour objet une porte logique de type OU-Exclusif 10 à deux entrées binaires a, b, comprenant une porte d'entrée NOR11 recevant les entrées a, b et fournissant un signal de sortie A1, une paire de portes NOR 12a, 12b recevant en commun le signal de sortie A1 de la porte d'entrée NOR et les entrées respectives a et b, et des moyens formant une fonction OR des signaux de sortie de la paire de portes, caractérisée en ce que la paire de portes est faite de deux amplificateurs réalisés en logique BDCFL et les moyens formant une fonction OR sont constitués par la sortie commune A de la paire de portes.

On a vu que la sortie commune A de la paire de portes 12a, 12b équivaut à mettre en commun le même transistor à déplétion servant de charge dans les deux tampons de la paire de portes.

Accessoirement, mais souvent avantageusement, la porte XOR 10 comportera des circuits de retard 13a et 13b pour retarder les entrées respectives a et b de façon à compenser sensiblement le retard fourni par la porte d'entrée et à appliquer les signaux retardés (a₁, b₁) sur des entrées respectives de la paire de portes. On a vu aussi que les tampons de sortie de ces circuits de retard permettent d'ajuster l'équilibrage des temps de commutation. Cependant, les circuits de retard 13a et 13b ne sont pas nécessaires si la dissymétrie ou l'allongement des temps de commutation n'est pas pénalisante.

Dans l'exemple illustré, les transistors de la paire de portes sont faits dans un semi-conducteur de type III-V. Dans le cas où le semi-conducteur est l'arséniure de gallium, les transistors de la paire de portes sont de type MESFET (Metal-Semiconductor Field-Effect Transistor). Dans le cas où le semi-conducteur est du type AlGaAs/GaAs, les transistors de la paire de portes peuvent être du type HEMT (High-Electron-Mobility Transistor). Ceci montre que ce principe peut être adapté aussi à d'autres technologies pouvant s'appliquer à la logique BDCFL. On a vu que les autres composants de la porte, tels que la porte d'entrée 11, peuvent être faits dans une autre logique compatible, telle que la DCFL.

Cependant, la logique BDCFL offre l'avantage sur la DCFL d'obtenir un signal de sortie correspondant au potentiel bas d'alimentation, la masse par exemple. La BDCFL permet donc d'avoir une porte bien immunisée au bruit.

Pour obtenir la fonction NON-OU Exclusif, il suffit par exemple de connecter la sortie commune A de la paire de portes à un inverseur non illustré, notamment du même type que celui des inverseurs 14. Cependant, d'autres modes de réalisation sont aussi possibles, tels que celui d'ajouter cet inverseur entre la porte 11 et la paire de portes 12a et 12b. Dans ces deux exemples, il suffit donc que la porte 10 incorpore un inverseur additionnel pour obtenir la fonction NON-OU Exclusif.

Enfin, on a vu que si les transistors d'entrée (Ei) de la paire de portes reçoivent leurs signaux (A1, a₁, b₁) de tampons (Eo, Do) d'amplificateurs de logique BDCFL comme dans l'exemple illustré, le rapport des largeurs de grille des deux transistors desdits tampons peut être ajusté de façon à équilibrer sensiblement les temps de commutation.

## Revendications

1. Porte logique de type OU-Exclusif (10) à deux entrées binaires a, b, comprenant une porte d'entrée NOR (11) recevant les entrées a, b et fournissant un signal de sortie (A1), une paire de portes NOR (12a, 12b) recevant en commun le signal de sortie (A1) de la porte d'entrée NOR et les entrées respectives a et b, et des moyens formant une fonction OR des signaux de sortie de la paire de portes, caractérisée en ce que la paire de portes est faite de deux amplificateurs réalisés en logique BDCFL et les moyens formant une fonction OR sont constitués par la sortie commune de la paire de portes.

2. Porte selon la revendication 1, caractérisée en ce que la sortie commune de la paire de portes consiste à mettre en commun le même transistor à déplétion servant de charge dans les deux tampons de la paire de portes.

3. Porte selon la revendication 1 ou 2, caractérisée en ce qu'elle comporte des circuits de retard (13a, 13b) pour retarder les entrées respectives a et b de façon à compenser sensiblement le retard fourni par la porte d'entrée et à appliquer les signaux retardés (a₁, b₁) sur des entrées respectives de la paire de portes.

4. Porte selon l'une des revendications 1 à 3, caractérisée en ce que les transistors de la paire de portes sont faits dans un semi-conducteur de type III-V, tel que l'arséniure de gallium ou du type AlGaAs/GaAs.

5. Porte selon la revendication 4, caractérisée en ce que les transistors de la paire de portes sont de type MESFET (Metal-Semiconductor Field-Effect Transistor).

6. Porte selon la revendication 4, caractérisée en ce que les transistors de la paire de portes sont de type HEMT (High-Electron-.Mobility Transistor).

7. Porte selon l'une des revendications 1 à 6, caractérisée en ce qu'elle incorpore un inverseur additionnel pour obtenir la fonction NON-OU Exclusif.

8. Porte selon l'une des revendications 1 à 7, caractérisée en ce que les transistors d'entrée (Ei) de la paire de portes recevant leurs signaux de tampons (Eo, Do) d'amplificateurs de logique BDCFL, le rapport des largeurs de grille des deux transistors desdits tampons est ajusté de façon à équilibrer sensiblement les temps de commutation.

9. Porte selon la revendication 8, caractérisé en ce que le rapport des largeurs de grille des transistors desdits tampons est de l'ordre de l'unité.

10. Circuit intégré comprenant une porte de type OU-Exclusif, caractérisé en ce que la porte est celle définie par l'une des revendications précédentes.
